# EUROPEAN PATENT APPLICATION

(11) **EP 4 287 448 A1**
(43) Date of publication of application: **06.12.2023**
(21) Application number: 22752120.0
(22) Date of filing: 24.01.2022
(51) Int. Cl.: H02J 7/00

(54) **ENERGY STORAGE SYSTEM, AND DETECTION METHOD FOR ENERGY STORAGE SYSTEM**

(30) Priority: 10.02.2021 CN 202110185168
(71) Applicant: Huawei Digital Power Technologies Co., Ltd., Shenzhen, Guangdong 518043 (CN)
(72) Inventor: LI, Lin, Shenzhen, Guangdong 518043 (CN); WU, Zhipeng, Shenzhen, Guangdong 518043 (CN)
(74) Representative: Huawei European IPR
(86) International application number: PCT/CN2022/073597
(87) International publication number: WO 2022/170959

(57) **Abstract**

This application provides an energy storage system and an energy storage system detection method. The method includes: A first control unit sends a first instruction to a first battery cluster, where the first instruction instructs to change an output voltage of the first battery cluster, and the first battery cluster is any one of a plurality of battery clusters. The first control unit obtains a first input voltage and a second input voltage that are of each of a plurality of power conversion units. The first control unit determines, based on the first instruction, and the first input voltage and the second input voltage that are of each of the plurality of power conversion units, whether each of the plurality of power conversion units is connected to the first battery cluster. According to the solutions of this application, a connection relationship between the plurality of battery clusters and the plurality of power conversion units in the energy storage system can be detected. On this basis, whether there is a connection error in the energy storage system is determined. Then, a security risk in the system is eliminated.

## Description

This application claims priority to Chinese Patent Application No. 202110185168.4, filed with the China National Intellectual Property Administration on February 10, 2021 and entitled "ENERGY STORAGE SYSTEM AND ENERGY STORAGE SYSTEM DETECTION METHOD", which is incorporated herein by reference in its entirety.

### TECHNICAL FIELD

This application relates to the field of electronic technologies, and in particular, to an energy storage system and an energy storage system detection method.

### BACKGROUND

An energy storage system includes a plurality of battery clusters and a plurality of power conversion units. When the energy storage system is constructed, the battery clusters and the power conversion units are usually made as a whole, and a manner in which the battery clusters are connected to the power conversion units has been fixed. This is not conducive to maintenance and system expansion. If the battery clusters and the power conversion units are made as two modules, there may be a connection error during installation. If there is the connection error in the system, the energy storage system may not work properly, or may even explode and be damaged after the energy storage system is started. Therefore, if the battery clusters and the power conversion units are made as two modules, when installation or commissioning of the system is completed, how to identify a connection relationship between the battery clusters and the power conversion units in the energy storage system is an urgent problem to be resolved.

### SUMMARY

This application provides an energy storage system and an energy storage system detection method, to detect a connection relationship between a plurality of battery clusters and a plurality of power conversion units in the energy storage system.

According to a first aspect, an energy storage system is provided. The energy storage system includes: a first control unit, a plurality of battery clusters, and a plurality of power conversion units. The plurality of battery clusters are configured to output voltages to the plurality of power conversion units. The plurality of power conversion units are configured to: receive the input voltages from the plurality of battery clusters, and output electric energy after performing direct current conversion. The first control unit is configured to: send a first instruction to a first battery cluster, where the first instruction instructs to change an output voltage of the first battery cluster, and the first battery cluster is any one of the plurality of battery clusters; obtain a first input voltage and a second input voltage that are of each of the plurality of power conversion units, where the first input voltage is an input voltage of each power conversion unit before the first instruction is sent, and the second input voltage is an input voltage of each power conversion unit after the first instruction is sent; and determine, based on the first instruction, and the first input voltage and the second input voltage that are of each of the plurality of power conversion units, whether each of the plurality of power conversion units is connected to the first battery cluster.

According to the technical solution of this application, the first control unit in the energy storage system may detect whether the first battery cluster is connected to each of the plurality of power conversion units, to determine a connection relationship between the first battery cluster and the plurality of power conversion units.

With reference to the first aspect, in some implementations of the first aspect, the first battery cluster includes a second control unit, a plurality of battery packs, and at least one switch circuit. A series circuit consists of the plurality of battery packs. The second control unit is configured to: receive the first instruction; and control, based on the first instruction, the at least one switch circuit to be turned on/off, to connect some battery packs in the first battery cluster to the series circuit or disconnect some battery packs in the first battery cluster from the series circuit.

In an embodiment of this application, the first battery cluster is provided with the switch circuit and the second control unit. As a result, the output voltage of the first battery cluster can be quickly changed, and the solution provided in this application can be implemented.

With reference to the first aspect, in some implementations of the first aspect, the first control unit is specifically configured to: determine a first voltage difference between voltages that are output by the first battery cluster before and after a voltage change instructed by the first instruction; determine a first threshold based on the first voltage difference, where the first threshold is less than or equal to the first voltage difference; determine a second voltage difference between a first input voltage and a second input voltage that are of a first power conversion unit, where the first power conversion unit is any one of the plurality of power conversion units; and when the second voltage difference is greater than the first threshold, determine that the first power conversion unit is connected to the first battery cluster; or when the second voltage difference is less than or equal to the first threshold, determine that the first power conversion unit is not connected to the first battery cluster.

With reference to the first aspect, in some implementations of the first aspect, each of the plurality of power conversion units is further configured to send information about the first input voltage and information about the second input voltage to the first control unit.

With reference to the first aspect, in some implementations of the first aspect, the first control unit is further configured to: obtain first information, where the first information includes a preset connection relationship between the first battery cluster and the plurality of power conversion units; and perform alarming when an actual connection relationship between the first battery cluster and the plurality of power conversion units is different from the preset connection relationship.

According to the technical solution of this application, after determining the connection relationship between the first battery cluster and the plurality of power conversion units in the energy storage system, the first control unit may further determine, based on the first information, whether there is a connection error in the energy storage system. Then, a problem in the system can be discovered in time, and a security risk in the system can be eliminated.

According to a second aspect, an energy storage system detection method is provided. An energy storage system includes: a first control unit, a plurality of battery clusters, and a plurality of power conversion units. The plurality of battery clusters are configured to output voltages to the plurality of power conversion units. The plurality of power conversion units are configured to: receive the input voltages from the plurality of battery clusters, and output electric energy after performing direct current conversion. The method includes: The first control unit sends a first instruction to a first battery cluster, where the first instruction instructs to change an output voltage of the first battery cluster, and the first battery cluster is any one of the plurality of battery clusters. The first control unit obtains a first input voltage and a second input voltage that are of each of the plurality of power conversion units, where the first input voltage is an input voltage of each power conversion unit before the first instruction is sent, and the second input voltage is an input voltage of each power conversion unit after the first instruction is sent. The first control unit determines, based on the first instruction, and the first input voltage and the second input voltage that are of each of the plurality of power conversion units, whether each of the plurality of power conversion units is connected to the first battery cluster.

According to the technical solution of this application, the first control unit in the energy storage system may detect whether the first battery cluster is connected to each of the plurality of power conversion units, to determine a connection relationship between the first battery cluster and the plurality of power conversion units.

With reference to the second aspect, in some implementations of the second aspect, the first battery cluster includes a second control unit, a plurality of battery packs, and at least one switch circuit. A series circuit consists of the plurality of battery packs. That the first control unit sends a first instruction to a first battery cluster includes: The first control unit sends the first instruction to the second control unit, so that the second control unit controls, based on the first instruction, the at least one switch circuit to be turned on/off, to connect some battery packs in the first battery cluster to the series circuit or disconnect some battery packs in the first battery cluster from the series circuit.

With reference to the second aspect, in some implementations of the second aspect, that the first control unit determines whether each of the plurality of power conversion units is connected to the first battery cluster includes: The first control unit determines a first voltage difference between voltages that are output by the first battery cluster before and after a voltage change instructed by the first instruction. The first control unit determines a first threshold based on the first voltage difference, where the first threshold is less than or equal to the first voltage difference. The first control unit determines a second voltage difference between a first input voltage and a second input voltage that are of a first power conversion unit, where the first power conversion unit is any one of the plurality of power conversion units. When the second voltage difference is greater than the first threshold, the first control unit determines that the first power conversion unit is connected to the first battery cluster; or when the second voltage difference is less than or equal to the first threshold, the first control unit determines that the first power conversion unit is not connected to the first battery cluster.

With reference to the second aspect, in some implementations of the second aspect, the method further includes: The first control unit obtains first information, where the first information includes a preset connection relationship between the first battery cluster and the plurality of power conversion units. The first control unit performs alarming when an actual connection relationship between the first battery cluster and the plurality of power conversion units is different from the preset connection relationship.

According to the technical solution of this application, after determining the connection relationship between the first battery cluster and the plurality of power conversion units in the energy storage system, the first control unit may further determine, based on the first information, whether there is a connection error in the energy storage system. Then, a problem in the system can be discovered in time, and a security risk in the system can be eliminated.

According to a third aspect, a first control unit of an energy storage system is provided. The energy storage system further includes a plurality of battery clusters and a plurality of power conversion units. The plurality of battery clusters are configured to output voltages to the plurality of power conversion units. The plurality of power conversion units are configured to: receive the input voltages from the plurality of battery clusters, and output electric energy after performing direct current conversion. The first control unit includes: a transceiver unit, configured to send a first instruction to a first battery cluster, where the first instruction instructs to change an output voltage of the first battery cluster, and the first battery cluster is any one of the plurality of battery clusters; and the transceiver unit is further configured to obtain a first input voltage and a second input voltage that are of each of the plurality of power conversion units, the first input voltage is an input voltage of each power conversion unit before the first instruction is sent, and the second input voltage is an input voltage of each power conversion unit after the first instruction is sent; and a processing unit, configured to: determine, based on the first instruction, and the first input voltage and the second input voltage that are of each of the plurality of power conversion units, whether each of the plurality of power conversion units is connected to the first battery cluster.

With reference to the third aspect, in some implementations of the third aspect, the first battery cluster includes a second control unit, a plurality of battery packs, and at least one switch circuit. A series circuit consists of the plurality of battery packs. The transceiver unit is configured to send the first instruction to the second control unit, so that the second control unit controls, based on the first instruction, the at least one switch circuit to be turned on/off, to connect some battery packs in the first battery cluster to the series circuit or disconnect some battery packs in the first battery cluster from the series circuit.

With reference to the third aspect, in some implementations of the third aspect, the processing unit is further configured to: determine a first voltage difference between voltages that are output by the first battery cluster before and after a voltage change instructed by the first instruction; determine a first threshold based on the first voltage difference, where the first threshold is less than or equal to the first voltage difference; determine a second voltage difference between a first input voltage and a second input voltage that are of a first power conversion unit, where the first power conversion unit is any one of the plurality of power conversion units; and when the second voltage difference is greater than the first threshold, determine that the first power conversion unit is connected to the first battery cluster; or when the second voltage difference is less than or equal to the first threshold, determine that the first power conversion unit is not connected to the first battery cluster.

With reference to the third aspect, in some implementations of the third aspect, the transceiver unit is further configured to obtain first information, where the first information includes a preset connection relationship between the first battery cluster and the plurality of power conversion units. The processing unit is further configured to perform alarming when an actual connection relationship between the first battery cluster and the plurality of power conversion units is different from the preset connection relationship.

### BRIEF DESCRIPTION OF DRAWINGS

FIG. 1 is a schematic diagram of an architecture of an energy storage system according to an embodiment of this application;
FIG. 2 is a schematic diagram of a manner of improving a battery cluster according to an embodiment of this application;
FIG. 3 is a schematic diagram of another manner of improving a battery cluster according to an embodiment of this application;
FIG. 4 is a schematic flowchart of a detection method according to this application;
FIG. 5 is a schematic flowchart of another detection method according to this application; and
FIG. 6 is a schematic block diagram of a first control unit according to this application.

### DESCRIPTION OF EMBODIMENTS

The following describes technical solutions of this application with reference to accompanying drawings.

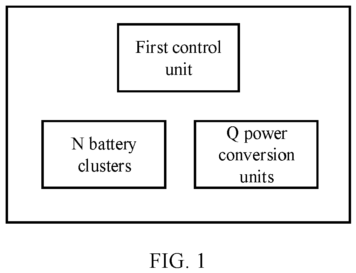

An energy storage system in this application is first described. As shown in FIG. 1, the energy storage system includes:
a first control unit, N battery clusters, and Q power conversion units, where N is greater than or equal to 2, and Q is greater than or equal to 2.

The following describes components of the energy storage system.

### 1. Battery cluster

The battery cluster is configured to output a voltage to the power conversion unit. One battery cluster usually includes m battery packs, and a series circuit consists of m battery packs, where m is greater than or equal to 1. To implement a detection method provided in this application, a structure of the battery cluster is improved, so that an output voltage of the battery cluster can be quickly changed. The following describes manners of improving the battery cluster.

### Manner 1:

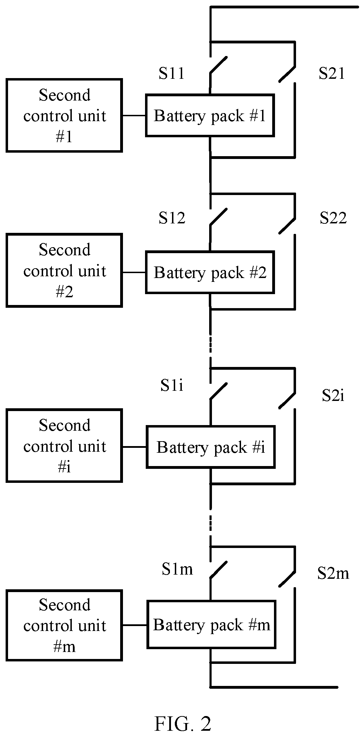

As shown in FIG. 2, a battery cluster is provided with a second control unit and at least one first switch circuit, and there may be one or more second control units. A battery pack #i in the battery cluster is used as an example. The first switch circuit includes a series circuit consisting of a single-pole single-throw switch S1i and the battery pack #i, and a parallel circuit consisting of a single-pole single-throw switch S2i, the battery pack #i, and the switch S1i. When the switch S 1i is turned off and the switch S2i is turned on, the battery pack #i may be disconnected from a series circuit. When the switch S 1i is turned on and the switch S2i is turned off, the battery pack #i may be connected to the series circuit. It should be understood that "disconnecting" a battery pack in this application means removing the battery pack from a series circuit, to reduce a quantity of battery packs included in the series circuit. "Connecting" a battery pack in this application means connecting the battery pack to a series circuit, to increase a quantity of battery packs included in the series circuit.

### Manner 2:

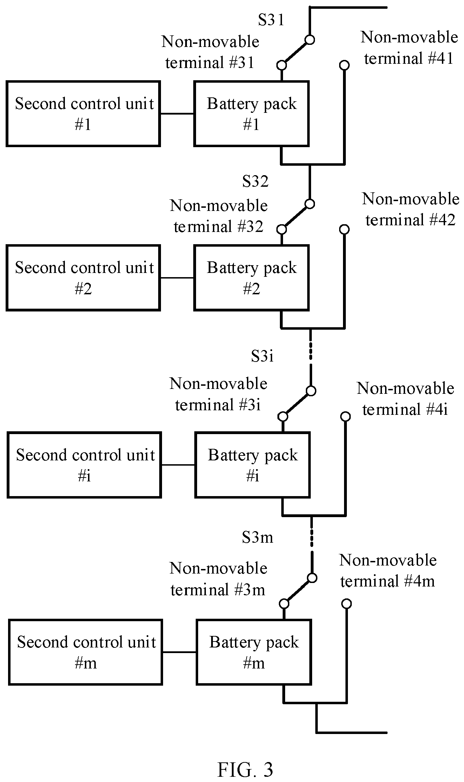

As shown in FIG. 3, a battery cluster is provided with a second control unit and at least one second switch circuit, and there may be one or more second control units. A battery pack #i in the battery cluster is used as an example. The second switch circuit includes a circuit consisting of a single-pole double-throw switch S3i and the battery pack #i. When a movable terminal of the switch S3i is switched to connect to a non-movable terminal #4i, the battery pack #i may be disconnected from a series circuit. When the movable terminal of the switch S3i is switched to connect to a non-movable terminal #3i, the battery pack #i may be connected to the series circuit.

It should be understood that the circuit connection manners in Manner 1 and Manner 2 are merely examples for description. A person skilled in the art may perform, based on an actual situation, the foregoing improvements on each battery pack, every two battery packs, or every other battery pack in the battery cluster. This is not limited in this application.

### 2. Power conversion unit

The power conversion unit is configured to: receive input voltages from the battery clusters, and output electric energy after performing direct current conversion. As an example instead of a limitation, the power conversion unit in this system may be a DC-DC converter, and the DC-DC converter may also be referred to as a direct current-direct current converter. It should be understood that a sample value of the input voltage of the power conversion unit may be used to indicate an output voltage of the battery cluster.

There are three types of basic DC-DC converters: a buck converter, a boost converter, and a buck-boost converter. The buck converter is a step-down converter, the boost converter is a step-up converter, and the buck-boost converter is a step-down/step-up converter. In the energy storage system shown in FIG. 1, a person skilled in the art may select a proper type of DC-DC converter based on an actual situation.

In the energy storage system shown in FIG. 1, there are Q power conversion units. A connection relationship between a battery cluster and a power conversion unit may be that one battery cluster is connected to one power conversion unit, one battery cluster is connected to a plurality of power conversion units, or a plurality of battery clusters are connected to one power conversion unit. That is, Q may be less than, equal to, or greater than N. This is not limited in this application.

### 3. First control unit

An energy storage system is usually provided with one first control unit. The N battery clusters and the Q power conversion units are separately connected to the first control unit through communication cables. In the detection method provided in this application, the first control unit may send an instruction to the battery cluster through the communication cable. Accordingly, the second control unit in the battery cluster receives the instruction, and controls the output voltage of the battery cluster based on the instruction. The power conversion unit may send the sample value of the input voltage to the first control unit through the communication cable. Accordingly, the first control unit receives the sample value of the input voltage of the power conversion unit.

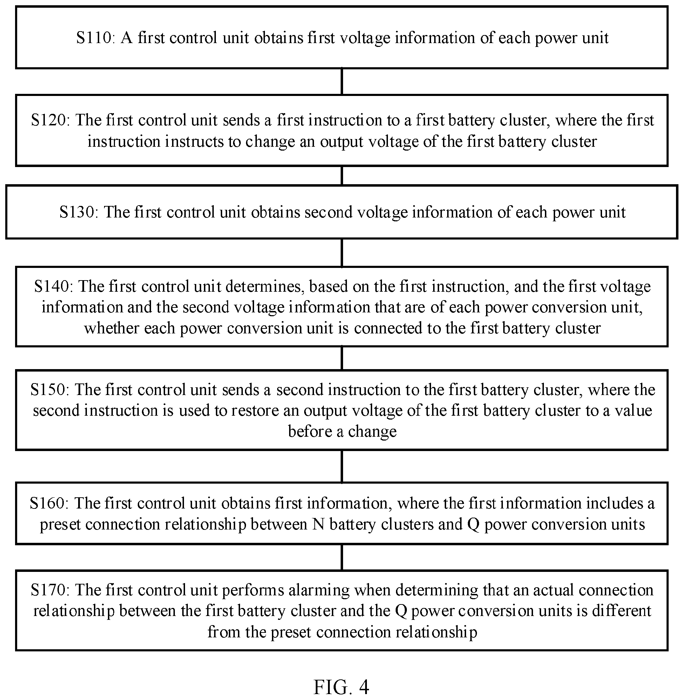

This application provides an energy storage system. The energy storage system includes a first control unit, N battery clusters, and Q power conversion units. The first control unit may be configured to detect a connection relationship between the N battery clusters and the Q power conversion units. For ease of understanding, the following describes a detection method provided in this application by using an example in which a connection relationship between a first battery cluster in the N battery clusters and the Q power conversion units is detected. The first battery cluster is any one of the N battery clusters, as shown in FIG. 4.

S110: Each of the Q power conversion units sends first voltage information to the first control unit, and accordingly, the first control unit obtains the first voltage information of each power conversion unit.

It should be understood that the first voltage information of each power conversion unit is used to indicate a first input voltage that is of each power conversion unit before a first instruction is sent.

S120: The first control unit sends the first instruction to a first battery cluster, where the first instruction instructs to change an output voltage of the first battery cluster; and accordingly, the first battery cluster receives the first instruction.

The following describes manners of changing the output voltage of the first battery cluster.

### Manner 3:

As shown in FIG. 2 or FIG. 3, a second control unit in the first battery cluster receives the first instruction, and decreases the output voltage of the first battery cluster.

For example, in FIG. 2, before the second control unit in the first battery cluster receives the first instruction, in the first battery cluster, switches S11 to S1m are all in an on state, and switches S21 to S2m are all in an off state. That is, m battery packs are all connected to a series circuit. A second control unit #1 receives the first instruction, turns off the switch 511, and turns on the switch S21. That is, the second control unit #1 disconnects a battery pack #1 from the series circuit.

For another example, in FIG. 3, before the second control unit in the first battery cluster receives the first instruction, switches S31 to S3i in the first battery cluster are connected to non-movable terminals #3i corresponding to the switches. That is, m battery packs are all connected to a series circuit. A second control unit #1 receives the first instruction, and switches the switch S31 to connect to a non-movable terminal #41. That is, the second control unit #1 disconnects a battery pack #1 from the series circuit.

After the battery pack #1 is disconnected from the series circuit, a quantity of battery packs in the series circuit is reduced, so that the output voltage of the first battery cluster is decreased. A decrease amount of the output voltage of the first battery cluster is associated with an output voltage of the battery pack #1. For example, the decrease amount of the output voltage of the first battery cluster is equal to the output voltage of the battery pack #1.

It should be understood that the foregoing is merely some specific manners of changing the output voltage of the first battery cluster, and this application is not limited thereto. For example, a manner of changing the output voltage of the first battery cluster may be alternatively as follows: A second control unit #1 and a second control unit #2 in the first battery cluster receive the first instruction, and disconnect a battery pack #1 and a battery pack #2 from the series circuit in the foregoing manner.

### Manner 4:

As shown in FIG. 2 or FIG. 3, a second control unit in the first battery cluster receives the first instruction, and increases the output voltage of the first battery cluster.

For example, in FIG. 2, before the second control unit in the first battery cluster receives the first instruction, in the first battery cluster, a switch S11 is turned off, a switch S21 is turned on, switches S12 to S1m are in an on state, and switches S22 to S2m are in an off state. That is, a battery pack #1 is not connected to a series circuit. A second control unit #1 receives the first instruction, turns on the switch S11, and turns off the switch S21. That is, the second control unit #1 connects the battery pack #1 to the series circuit.

For another example, in FIG. 3, before the second control unit in the first battery cluster receives the first instruction, in the first battery cluster, a switch S31 is connected to a corresponding non-movable terminal #41, and S32 to S3m are connected to non-movable terminals #3i corresponding to the switches. That is, a battery pack #1 is not connected to a series circuit. The second control unit #1 receives the first instruction, and switches the switch S31 to connect to a non-movable terminal #31. That is, a battery pack #1 is connected to the series circuit.

After the battery pack #1 is connected to the series circuit, a quantity of battery packs in the series circuit is increased, so that the output voltage of the first battery cluster is increased. An increase amount of the output voltage of the first battery cluster is associated with an output voltage of the battery pack #1. For example, the increase amount of the output voltage of the first battery cluster is equal to the output voltage of the battery pack #1.

It should be understood that the foregoing is merely some specific manners of changing the output voltage of the first battery cluster, and this application is not limited thereto. For example, a manner of changing the output voltage of the first battery cluster may be alternatively as follows: Before the first instruction is received, a battery pack #1 and a battery pack #2 in the first battery cluster are not connected to the series circuit. A second control unit #1 and a second control unit #2 connect the battery pack #1 and the battery pack #2 to the series circuit based on the received first instruction in the foregoing manner.

S130: Each of the Q power conversion units sends second voltage information to the first control unit, and accordingly, the first control unit obtains the second voltage information of each power conversion unit.

It should be understood that the second voltage information of each power conversion unit is used to indicate a second input voltage that is of each power conversion unit after the first instruction is sent.

In a possible implementation, S130 is performed immediately after S120.

In another possible implementation, S130 may be performed after an interval of T following S120. For example, T is two seconds. The interval T is set to wait for the output voltage of the first battery cluster to stabilize, to improve accuracy of the second input voltage that is of each power conversion unit and that is obtained by the first control unit.

S140: The first control unit determines, Based on the first instruction, and the first voltage information and the second voltage information that are of each power conversion unit, whether each power conversion unit is connected to the first battery cluster.

The following describes manners of determining whether each power conversion unit is connected to the first battery cluster.

### Manner 5:

Corresponding to manner 3 in S120, the first control unit determines a first voltage difference between voltages that are of the first battery cluster before and after a voltage change instructed by the first instruction. The first voltage difference is associated with a battery pack that is disconnected from the series circuit.

For example, in Manner 3, the first instruction instructs the second control unit #1 in the first battery cluster to disconnect the battery pack #1 from the series circuit. The output voltage of the battery pack #1 is 50 V, and the first control unit determines that the first voltage difference is 50 V

The first control unit determines a first threshold based on the first voltage difference, where the first threshold is less than or equal to the first voltage difference.

For example, when the first voltage difference is 50 V, it may be determined that the first threshold is 47 V

The first control unit determines whether a decrease amount (an example of a second voltage difference) of the second input voltage of each power conversion unit compared to the first input voltage of each power conversion unit is greater than the first threshold. It is determined that a power conversion unit is connected to the first battery cluster, where a decrease amount of a second input voltage of the power conversion unit compared to a first input voltage of the power conversion unit is greater than the first threshold.

For example, there are three power conversion units in total in the system. A first input voltage and a second input voltage that are of each power conversion unit are shown in Table 1. It should be understood that values in Table 1 are merely examples for description, and this is not limited in this application.

**Table 1**

| | Power conversion unit #1 | Power conversion unit #2 | Power conversion unit #3 |
|---|---|---|---|
| First input voltage/V | 1000 | 1000 | 1000 |
| Second input voltage/V | 950 | 990 | 952 |
| Voltage decrease amount/V | 50 | 10 | 48 |

It can be learned from Table 1 that, a decrease amount of a second input voltage of a power conversion unit #1 compared to a first input voltage of the power conversion unit #1 is greater than the first threshold, a decrease amount of a second input voltage of a power conversion unit #2 compared to a first input voltage of a power conversion unit #2 is less than the first threshold, and a decrease amount of a second input voltage of a power conversion unit #3 compared to a first input voltage of the power conversion unit #3 is greater than the first threshold. In this case, it may be determined that the first battery cluster is connected to the power conversion unit #1 and the power conversion unit #3.

### Manner 6:

Corresponding to manner 4 in S120, the first control unit determines a first voltage difference between voltages that are of the first battery cluster before and after a voltage change instructed by the first instruction. The first voltage difference is associated with a battery pack that is connected to the series circuit.

For example, in Manner 4, the first instruction instructs the second control unit #1 in the first battery cluster to connect the battery pack #1 to the series circuit. The output voltage of the battery pack #1 is 50 V, and the first control unit determines that the first voltage difference is 50 V

The first control unit determines a first threshold based on the first voltage difference, where the first threshold is less than or equal to the first voltage difference.

For example, when the first voltage difference is 50 V, it may be determined that the first threshold is 47 V

The first control unit determines whether an increase amount (an example of a second voltage difference) of the second input voltage of each power conversion unit compared to the first input voltage of each power conversion unit is greater than the first threshold. It is determined that a power conversion unit is connected to the first battery cluster, where an increase amount of a second input voltage of the power conversion unit compared to a first input voltage of the power conversion unit is greater than the first threshold.

For example, there are three power conversion units in total in the system. A first input voltage and a second input voltage that are of each power conversion unit are shown in Table 2. It should be understood that values in Table 2 are merely examples for description, and this is not limited in this application.

**Table 2**

| | Power conversion unit #1 | Power conversion unit #2 | Power conversion unit #3 |
|---|---|---|---|
| First voltage/V | 1000 | 1000 | 1000 |
| Second voltage/V | 1050 | 1005 | 1048 |
| Voltage increase amount/V | 50 | 5 | 48 |

It can be learned from Table 2 that, an increase amount of a second input voltage of a power conversion unit #1 compared to a first input voltage of the power conversion unit #1 is greater than the first threshold, an increase amount of a second input voltage of a power conversion unit #2 compared to a first input voltage of the power conversion unit #2 is less than the first threshold, and an increase amount of a second input voltage of a power conversion unit #3 compared to a first input voltage of the power conversion unit #3 is greater than the first threshold. In this case, it may be determined that the first battery cluster is connected to the power conversion unit #1 and the power conversion unit #3.

It should be understood that the first control unit may determine the connection relationship between the first battery cluster and the Q power conversion units through S110 to S140. Similarly, the first control unit may determine a connection relationship between another battery cluster and the Q power conversion units in the energy storage system.

In a possible implementation, the detection method further includes the following step.

S150: The first control unit sends a second instruction to the first battery cluster, where the second instruction is used to restore the output voltage of the first battery cluster to a value before the change.

The following describes manners of restoring the output voltage of the first battery cluster to the value before the change.

### Manner 7:

In Manner 3 of S120, the second control unit #1 in the first battery cluster disconnects the battery pack #1 from the series circuit based on the received first instruction. Correspondingly, in S150, the second control unit #1 in the first battery cluster connects the battery pack #1 to the series circuit based on the received second instruction.

### Manner 8:

In Manner 4 of S120, the second control unit #1 in the first battery cluster connects the battery pack #1 to the series circuit based on the received first instruction. Correspondingly, in S150, the second control unit #1 in the first battery cluster disconnects the battery pack #1 from the series circuit based on the received second instruction.

S160: The first control unit obtains first information, where the first information includes a preset connection relationship between the N battery clusters and the Q power conversion units, that is, the first information includes a preset connection relationship between the first battery cluster and the Q power conversion units.

In a possible implementation, the first information may be manually configured.

S170: The first control unit performs alarming when determining that an actual connection relationship between the first battery cluster and the Q power conversion units is different from the preset connection relationship.

For example, the preset connection relationship that is between the first battery cluster and the Q power conversion units and that is included in the first information is that the first battery cluster is connected to one power conversion unit. The first control unit performs alarming when determining, through S110 to S140, that the first battery cluster is connected to two power conversion units.

For another example, the preset connection relationship that is between the first battery cluster and the Q power conversion units and that is included in the first information is that the first battery cluster is connected to the power conversion unit #1. The first control unit performs alarming when determining, through S110 to S140, that the first battery cluster is connected to the power conversion unit #2.

It should be understood that the foregoing examples in which the first control unit determines that the actual connection relationship between the first battery cluster and the Q power conversion units is different from the preset connection relationship are merely examples for description, and other similar examples are not listed one by one herein.

In this embodiment of this application, after the connection relationship between the first battery cluster and the Q power conversion units in the energy storage system is determined, it may be further determined whether the actual connection relationship between the first battery cluster and the Q power conversion units is the same as the preset connection relationship. Then, a connection error in the system can be discovered in time, and a security risk in the system can be eliminated.

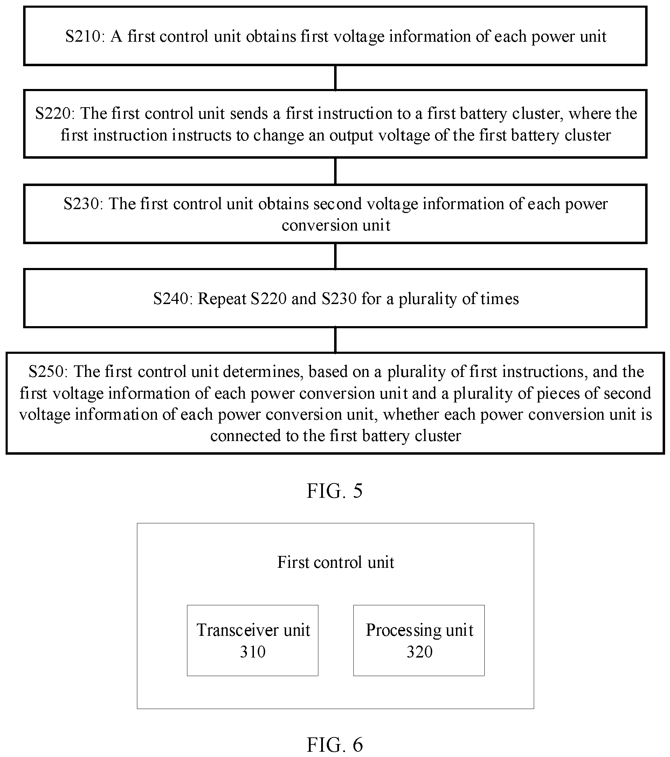

The following describes another method for detecting a connection relationship between a first battery cluster and Q power conversion units provided in this application, as shown in FIG. 5.

S210: Each of the Q power conversion units sends first voltage information to a first control unit, and accordingly, the first control unit obtains the first voltage information of each power conversion unit.

This process may be similar to S110.

S220: The first control unit sends a first instruction to a first battery cluster, where the first instruction instructs to change an output voltage of the first battery cluster; and accordingly, the first battery cluster receives the first instruction.

A manner of changing the output voltage of the first battery cluster may be similar to that in S 120.

S230: Each of the Q power conversion units sends second voltage information to the first control unit, and accordingly, the first control unit obtains the second voltage information of each power conversion unit.

S240: Repeat S220 and S230 for a plurality of times.

S250: Based on a plurality of first instructions, and the first voltage information and a plurality of pieces of second voltage information that are of each power conversion unit, the first control unit determines whether each power conversion unit is connected to the first battery cluster.

The following describes a manner of determining whether each power conversion unit is connected to the first battery cluster. For ease of description, an example in which S220 and S230 are repeated for three times and there are three power conversion units in total is used for description. It should be understood that a quantity of times for which S220 and S230 are repeated and a quantity of power conversion units are not limited in this application.

The first control unit determines a second threshold, where the second threshold is associated with a quantity of times for which S220 and S230 are repeated. For example, when S220 and S230 are repeated for three times, it may be determined that the second threshold is 2.

For example, when S220 and S230 are not performed, battery packs #1 to #m in the first battery cluster are connected to a series circuit in the manner shown in FIG. 2 or FIG. 3. An output voltage of each battery pack is 50 V

When S220 and S230 are performed for the first time, a second control unit #1 receives the first instruction, and disconnects the battery pack #1 from the series circuit. The first control unit obtains a second input voltage #1 of each power conversion unit.

When S220 and S230 are performed for the second time, a second control unit #2 receives the first instruction, and disconnects a battery pack #2 from the series circuit based on the first execution of S220. The first control unit obtains a second input voltage #2 of each power conversion unit.

When S220 and S230 are performed for the third time, a second control unit #3 receives the first instruction, and disconnects a battery pack #3 from the series circuit based on the first execution and the second execution of S220. The first control unit obtains a second input voltage #3 of each power conversion unit.

The first control unit determines a first voltage difference between voltages that are of the first battery cluster before and after a voltage change instructed by the first instruction. The first voltage difference is associated with a battery pack that is disconnected from the series circuit each time. One battery pack is disconnected each time, and the output voltage of each battery pack is 50 V Therefore, the first control unit determines that the first voltage difference is 50 V

The first control unit determines a first threshold based on the first voltage difference, where the first threshold is less than or equal to the first voltage difference.

For example, when the first voltage difference is 50 V, it may be determined that the first threshold is 47 V

Information obtained by the first control unit is shown in Table 3. A voltage decrease amount is a difference between two consecutive input voltages of each power conversion unit, for example, a voltage decrease amount of the second input voltage #1 compared to the first input voltage, a voltage decrease amount of the second input voltage #2 compared to the second input voltage #1, and a voltage decrease amount of the second input voltage #3 compared to the second input voltage #2. It should be understood that values in Table 3 are merely examples for description, and this is not limited in this application.

The first control unit determines a quantity of voltage decrease amounts that are in the three voltage decrease amounts of each power conversion unit and that are greater than the first threshold. It is determined that a power conversion unit is connected to the first battery cluster, where a quantity is greater than or equal to the second threshold.

**Table 3**

| | Power conversion unit #1 | Power conversion unit #2 | Power conversion unit #3 |
|---|---|---|---|
| First input voltage/V | 1000 | 1000 | 1000 |
| Second input voltage #1 (voltage decrease amount)/V | 950 (50) | 995 (5) | 952 (48) |
| Second input voltage #2 (voltage decrease amount)/V | 902 (48) | 994 (1) | 902 (50) |
| Second input voltage #3 (voltage decrease amount)/V | 850 (52) | 940 (50) | 857 (45) |
| Quantity | 3 | 1 | 2 |

It can be learned from Table 3 that, a quantity of voltage decrease amounts that are in three voltage decrease amounts of the power conversion unit #1 and that are greater than the first threshold is greater than the second threshold, a quantity of voltage decrease amounts that are in three voltage decrease amounts of the power conversion unit #2 and that are greater than the first threshold is less than the second threshold, and a quantity of voltage decrease amounts that are in the three voltage decrease amounts of the power conversion unit #3 and that are greater than the first threshold is equal to the second threshold. Therefore, the first control unit determines that the first battery cluster is connected to the power conversion unit #1 and the power conversion unit #3.

Similarly, S220 and S230 may be further repeated for three times in S240, and the battery pack #1, the battery pack #2, and the battery pack #3 of the first battery cluster are separately connected to the series circuit. It should be understood that when S220 and S230 are not performed, the battery pack #1, the battery pack #2, and the battery pack #3 are in a state of disconnected from the series circuit. The first control unit obtains three pieces of second voltage information corresponding to each power conversion unit. The first control unit determines a quantity of voltage increase amounts that are in three voltage increase amounts of each power conversion unit and that are greater than the first threshold. It is determined that a power conversion unit is connected to the first battery cluster, where a quantity is greater than or equal to the second threshold. For example, the voltage increase amount is a voltage increase amount of the second input voltage #1 of each power conversion unit compared to the first input voltage of each power conversion unit, or a voltage increase amount of the second input voltage #2 of each power conversion unit compared to the second input voltage #1 of each power conversion unit, or a voltage increase amount of the second input voltage #3 of each power conversion unit compared to the second input voltage #2 of each power conversion unit.

Similarly, S220 and S230 may be further repeated for three times in S240. For the first two times, the battery pack #1 and the battery pack #2 that are of the first battery cluster are separately disconnected from the series circuit. For the third time, the battery pack #1 is connected to the series circuit. It should be understood that when S220 and S230 are not performed, the battery pack #1 and the battery pack #2 are in a state of connected to the series circuit. The first control unit obtains three pieces of second voltage information of each power conversion unit. The first control unit determines a decrease amount of the second input voltage #1 of each power conversion unit compared to the first input voltage of each power conversion unit, a decrease amount of the second input voltage #2 of each power conversion unit compared to the second input voltage #1 of each power conversion unit, and an increase amount of the second input voltage #3 of each power conversion unit compared to the second input voltage #2 of each power conversion unit, and determines a quantity of voltage change amounts that are in the three voltage change amounts and that are greater than the first threshold. It is determined that a power conversion unit is connected to the first battery cluster, where a quantity is greater than or equal to the second threshold.

According to the solution provided in this application, S220 and S230 are repeated for a plurality of times, and the first control unit determines, based on results obtained by repeating S220 and S230 for the plurality of times, the power conversion unit connected to the first battery cluster in the Q power conversion units. Compared with performing S220 and S230 only once, this solution can improve detection accuracy and decrease a probability of erroneous determination.

It should be understood that the first control unit may determine the connection relationship between the first battery cluster and the Q power conversion units through S210 to S250. Similarly, the first control unit may further determine a connection relationship between another battery cluster and the Q power conversion units in an energy storage system.

Similar to those in the foregoing description, after S250, the first control unit may further send a second instruction to the first battery cluster, where the second instruction is used to restore the output voltage of the first battery cluster to a value before the change, and obtain first information. The first control unit performs alarming when determining that an actual connection relationship between the first battery cluster and the Q power conversion units is different from a preset connection relationship. Details are not described herein again.

According to the foregoing method, FIG. 6 is a schematic block diagram of a first control unit according to an embodiment of this application. The first control unit includes a transceiver unit 310 and a processing unit 320. The transceiver unit 310 and the processing unit 320 can support actions performed by the first control unit in the foregoing method examples. For example, the transceiver unit 310 can support the first control unit to perform S110, S120, and S130 in FIG. 4, and/or another process of the technology described in this specification; and the processing unit 320 can support the first control unit to perform S140 and S170 in FIG. 4, and/or another process of the technology described in this specification.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An energy storage system, wherein the energy storage system comprises: a first control unit, a plurality of battery clusters, and a plurality of power conversion units;
the plurality of battery clusters are configured to output voltages to the plurality of power conversion units;
the plurality of power conversion units are configured to: receive the input voltages from the plurality of battery clusters, and output electric energy after performing direct current conversion; and
the first control unit is configured to:
send a first instruction to a first battery cluster, wherein the first instruction instructs to change an output voltage of the first battery cluster, and the first battery cluster is any one of the plurality of battery clusters;
obtain a first input voltage and a second input voltage that are of each of the plurality of power conversion units, wherein the first input voltage is an input voltage of each power conversion unit before the first instruction is sent, and the second input voltage is an input voltage of each power conversion unit after the first instruction is sent; and
determine, based on the first instruction, and the first input voltage and the second input voltage that are of each of the plurality of power conversion units, whether each of the plurality of power conversion units is connected to the first battery cluster.

2. The system according to claim 1, wherein the first battery cluster comprises a second control unit, a plurality of battery packs, and at least one switch circuit; a series circuit consists of the plurality of battery packs; and
the second control unit is configured to:
receive the first instruction; and
control, based on the first instruction, the at least one switch circuit to be turned on/off, to connect some battery packs in the first battery cluster to the series circuit or disconnect some battery packs in the first battery cluster from the series circuit.

3. The system according to claim 1 or 2, wherein the first control unit is specifically configured to:
determine a first voltage difference between voltages that are output by the first battery cluster before and after a voltage change instructed by the first instruction;
determine a first threshold based on the first voltage difference, wherein the first threshold is less than or equal to the first voltage difference;
determine a second voltage difference between a first input voltage and a second input voltage that are of a first power conversion unit, wherein the first power conversion unit is any one of the plurality of power conversion units; and
when the second voltage difference is greater than the first threshold, determine that the first power conversion unit is connected to the first battery cluster; or
when the second voltage difference is less than or equal to the first threshold, determine that the first power conversion unit is not connected to the first battery cluster.

4. The system according to any one of claims 1 to 3, wherein each of the plurality of power conversion units is further configured to send information about the first input voltage and information about the second input voltage to the first control unit.

5. The system according to any one of claims 1 to 4, wherein the first control unit is further configured to:
obtain first information, wherein the first information comprises a preset connection relationship between the first battery cluster and the plurality of power conversion units; and
perform alarming when an actual connection relationship between the first battery cluster and the plurality of power conversion units is different from the preset connection relationship.

6. An energy storage system detection method, wherein an energy storage system comprises a first control unit, a plurality of battery clusters, and a plurality of power conversion units; the plurality of battery clusters are configured to output voltages to the plurality of power conversion units; the plurality of power conversion units are configured to: receive the input voltages from the plurality of battery clusters, and output electric energy after performing direct current conversion; and the method comprises:
sending, by the first control unit, a first instruction to a first battery cluster, wherein the first instruction instructs to change an output voltage of the first battery cluster, and the first battery cluster is any one of the plurality of battery clusters;
obtaining, by the first control unit, a first input voltage and a second input voltage that are of each of the plurality of power conversion units, wherein the first input voltage is an input voltage of each power conversion unit before the first instruction is sent, and the second input voltage is an input voltage of each power conversion unit after the first instruction is sent; and
determining by the first control unit, based on the first instruction, and the first input voltage and the second input voltage that are of each of the plurality of power conversion units, whether each of the plurality of power conversion units is connected to the first battery cluster.

7. The method according to claim 6, wherein
the first battery cluster comprises a second control unit, a plurality of battery packs, and at least one switch circuit; a series circuit consists of the plurality of battery packs; and
the sending, by the first control unit, a first instruction to a first battery cluster comprises:
sending, by the first control unit, the first instruction to the second control unit, so that the second control unit controls, based on the first instruction, the at least one switch circuit to be turned on/off, to connect some battery packs in the first battery cluster to the series circuit or disconnect some battery packs in the first battery cluster from the series circuit.

8. The method according to claim 6 or 7, wherein the determining, by the first control unit, whether each of the plurality of power conversion units is connected to the first battery cluster comprises:
determining, by the first control unit, a first voltage difference between voltages that are output by the first battery cluster before and after a voltage change instructed by the first instruction;
determining, by the first control unit, a first threshold based on the first voltage difference, wherein the first threshold is less than or equal to the first voltage difference;
determining, by the first control unit, a second voltage difference between a first input voltage and a second input voltage that are of a first power conversion unit, wherein the first power conversion unit is any one of the plurality of power conversion units; and
when the second voltage difference is greater than the first threshold, determining, by the first control unit, that the first power conversion unit is connected to the first battery cluster; or
when the second voltage difference is less than or equal to the first threshold, determining, by the first control unit, that the first power conversion unit is not connected to the first battery cluster.

9. The method according to any one of claims 6 to 8, wherein the method further comprises:
obtaining, by the first control unit, first information, wherein the first information comprises a preset connection relationship between the first battery cluster and the plurality of power conversion units; and
performing, by the first control unit, alarming when an actual connection relationship between the first battery cluster and the plurality of power conversion units is different from the preset connection relationship.
